(19) Europäisches Patentamt

European Patent Office

Office européen des brevets

(11) **EP 1 156 341 B1**

(12) **EUROPÄISCHE PATENTSCHRIFT**

(45) Veröffentlichungstag und Bekanntmachung des Hinweises auf die Patenterteilung:
**01.03.2006  Patentblatt 2006/09**

(51) Int Cl.:
***G01R 31/11*** *(2006.01)*

(21) Anmeldenummer: **01112186.0**

(22) Anmeldetag: **18.05.2001**

(54) **Verfahren zur Korrektur der frequenz- und längenabhängigen Leitungsdämpfung bei TDR-Messungen an Hochfrequenzkabeln**

Method for correcting frequency- and length-dependent line attenuation for tdr-measurements carried out on high-frequency cables

Procédé de correction de l'atténuation de ligne en fréquence et en longueur lors de mesures par réflectométrie à domaine temporel sur des cables haute-fréquence

(84) Benannte Vertragsstaaten:
**AT BE CH CY DE DK ES FI FR GB GR IE IT LI LU MC NL PT SE TR**

(30) Priorität: **18.05.2000   DE 10024085**

(43) Veröffentlichungstag der Anmeldung:
**21.11.2001   Patentblatt 2001/47**

(73) Patentinhaber: **T-Mobile Deutschland GmbH 53227 Bonn (DE)**

(72) Erfinder:
  • **Nowok, Gregor 90455 Nürnberg (DE)**
  • **Pospiech, Peter 91330 Eggolsheim (DE)**

(74) Vertreter: **Riebling, Peter Patentanwalt Postfach 31 60 88113 Lindau (DE)**

(56) Entgegenhaltungen:
**EP-A- 0 768 537          US-A- 4 630 228**

**Beschreibung**

Die Erfindung betrifft ein Verfahren zur Korrektur der frequenzabhängigen Leitungsdämpfung bei TDR-Messungen an Hochfrequenzkabeln nach den Merkmalen des Oberbegriffs des Patentanspruchs 1.

Die EP 99960907.6 (= PCT/DE99-03650) beschreibt ein ähnliches Verfahren bei FDR-Messungen.

Das Reflektionsverhalten von Leitungen und Leitungsübergängen bei Kabeln wird mittels TDR (Time Domain Reflectometry) bzw. FDR (Frequency Domain Reflectometry)-Messgeräten ermittelt. Damit lassen sich Fehlerstellen in Kabeln, Leitungen und Leitungssystemen, insbesondere an Leitungsübergängen, bestimmen und genau lokalisieren. Es sind Messverfahren bekannt, bei denen die Messung am Kabel oder Leitungssystem im Zeitbereich erfolgt und das Ergebnis auf einem Bildschirm des Messgerätes (Oszilloskop oder Computer) angezeigt wird, bzw. eine Ausgabe auf Papier möglich ist.

Die derzeit käuflichen Messgeräte arbeiten ohne Korrektur bzw. nur mit schmalbandiger Korrektur der frequenz- und längenabhängigen Leitungsdämpfung der gemessenen Kabel. Die individuelle frequenz- und längenabhängige Dämpfung des Kabels verfälscht die Messergebnisse und erschwert es, tatsächliche Fehlerquellen mit Sicherheit zu erkennen bzw. die Güte der Leitungsanpassung zu beurteilen. Im Interesse eines guten Messergebnisses, d.h. einer sehr guten Auflösung im Zeitbereich, sollten die Messungen im Zweitbereich mit Impulsfolgen mit kurzen Anstiegszeiten ausgeführt werden. Das Ergebnis einer derartigen Messung ist jedoch ohne bzw. ohne umfassende Korrektur der frequenz- und längenabhängigen Leitungsdämpfung der gemessenen Kabel nur äußerst schwierig interpretierbar, wenn es sich um größere Kabellängen handelt.

Die Aufgabe der Erfindung liegt deshalb darin, ein Verfahren zur Korrektur der frequenzabhängigen Leitungsdämpfung bei Messungen an Hochfrequenzkabeln vorzuschlagen, mit welchem bei Messung mit steilen Impulsen bzw. Impulsfolgen im Zeitbereich wesentlich genauere Messwerte über den gesamten Längenbereich des Kabels erzielt werden können.

Gelöst wird diese Aufgabe durch die kennzeichnenden Merkmale des Patentanspruchs 1.

Die Erfindung beruht darauf, daß für jeden zu messenden Kabeltyp aus vom Hersteller vorgegeben Dämpfungswerten ein Parametersatz für ein Dämpfungsmodell erzeugt wird. Anhand dieses Dämpfungsmodells lässt sich im Zeitbereich eine längenabhängige Korrekturfunktion angeben, mir der dann die ebenfalls im Zeitbereich gemessenen Messwerte des komplexen Reflektionsfaktors korrigiert werden, wobei sich physikalisch richtige Werte ergeben.

Dadurch wird der Vorteil erreicht, daß die Fehler der Messungen im Frequenzbereich, hervorgerufen durch eine frequenzabhängige und längenabhängige Leitungsdämpfung, im Zeitbereich korrigiert werden und die resultierenden Messergebnisse erheblich genauer und auf der ganzen Kabellänge untereinander besser vergleichbar werden.

Damit ist der weitere Vorteil gegeben, daß eine Korrektur des frequenz- und längenabhängigen Fehlers mit hoher zeitlicher Auflösung erzielt werden kann.

Vorteilhafte Ausgestaltungen und Weiterbildungen der Erfindung sind Gegenstand der abhängigen Patentansprüche.

So ist z.B. vorgesehen, zur besseren Handhabung die Anregungssprungfunktion unter Zwischenschaltung eines Hochpasses in eine Stoßfunktion umzuformen, um die Weiterverarbeitung der Stoßantwortsignale ohne Gleichpegelanteil zu ermöglichen.

Nachfolgend wird die Erfindung anhand eines Ausführungsbeispiels unter Bezugnahme auf Zeichnungen näher erläutert. Dabei gehen aus den Zeichnungen und ihrer Beschreibung weitere Merkmale und Vorteile der Erfindung hervor.

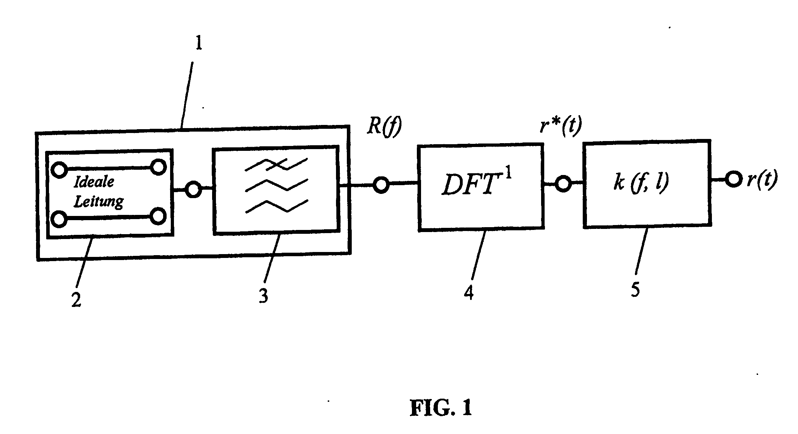

Figur 1 zeigt ein Blockschaltbild zur erfindungsgemäßen Korrektur der längen- und frequenzabhängigen Leitungsdämpfung bei TDR-Messungen an Leitungssystemen;

Figur 1 zeigt schematisch ein Blockschaltbild einer zu messenden Hochfrequenzleitung 1. Ausgehend von einer idealen Leitung 2 weist jede Leitung eine definierte frequenz- und längenabhängigen Dämpfung 3 auf, die durch eine zu bestimmende Näherungsfunktion beschrieben werden kann.

Näherungsfunktion für die frequenzabhängige Dämpfung

Die Leitungsdämpfung für eine vorgegebene Länge und Frequenz wird an einer an einem Ende kurzgeschlossenen Leitung bestimmter Länge ermittelt. Für eine kurzgeschlossene Leitung der Länge $l_0$ läßt sich der Eingangsreflektionsfaktor $r(f, l_0)$ folgendermaßen angeben:

$$r(f, l_0) = -1 \cdot e^{-2 \cdot [\alpha(f) + j \cdot \beta(f)] \cdot l_0} \tag{1}$$

mit

  $\alpha(f)$ Dämpfung, als Funktion der Frequenz
  $\beta(f)$ Phase als Funktion der Frequenz

Der Betrag ist somit:

$$|r(f,l_0)| = e^{-2\cdot\alpha(f)\cdot l_0} \tag{2}$$

Der Retumloss $a_R(f,l_0)$ stellt die doppelte Leitungsdämpfung dar und ergibt sich zu:

$$2\cdot a_R(f,l_0) = 20\cdot \lg\{|r(f,l_0)|\} = \frac{-40}{\ln(10)}\cdot\alpha(f)\cdot l_0 \tag{3}$$

Die Kabelhersteller geben in der Regel die Leitungsdämpfung für fünf bestimmte Frequenzen an. Die Funktion der einfachen Kabeldämpfung $a_{RN}(f,l_0)$ über der Frequenz läßt sich sehr gut durch folgende Funktion annähern:

$$a_{R_N}(f,l_0) = a\cdot f^b\cdot l_0 \tag{4}$$

Durch Gleichsetzen der beiden Ausdrücke $a_{RN}(f,l_0)$ und $a_R(f,l_0)$, d.h. der Gleichungen (3) und (4), erhält man die frequenzabhängige Dämpfung $\alpha(f)$, die sich ergibt zu:

$$\alpha(f) = -\frac{\ln(10)}{20}\cdot a\cdot f^b \tag{5}$$

Die Konstanten $a$ und $b$ sind leitungsspezifische Parameter. Diese können durch die Methode der kleinsten Fehlerquadrate bestimmt werden.

Misst man nun mittels des TDR-Verfahrens den die Sprung- bzw. Stoßantwortfunktion des betrachteten Kabels 1. Der daraus ermittelte Reflektionsfaktor im Zeitbereich ist fehlerbehaftet, hervorgerufen durch die frequenz- und längenabhängige Dämpfung des gemessenen Kabels 1. Um diese Fehler auszugleichen, wird nun erfindungsgemäss vorgeschlagen, eine Korrektur 5 auf die Messwerte r*(t) anzuwenden. Damit erhält man berichtigte Messwerte, unabhängig von der kabelspezifischen Dämpfung. Die Korrektur 5 erfolgt durch eine Korrekturfunktion k(f, l).

Die Ermittlung der Korrekturfunktion geschieht folgendermaßen:

Es wird das Spekturm des Anregungsimpulses bzw. der -Impulsfolge unter Durchführung von "Kalibriermessungen" mit Kurzschluss und Leerlauf als Messobjekt ermittelt und geeignet abgespeichert. Dies so ermittelten Messwerte stellen einen Vektor dar mit Amplituden in Abhängigkeit von der Zeit.

Dieser Vektor wird danach mittels Diskreter Fouriertransformation (DFT) in den Frequenzbereich transformiert und ergibt das diskrete Spektrum des Impulses bzw. der Impulsfolge. Gegebenenfalls wird der Anregungsimpuls bzw. die - impulsfolge noch über ein Hochpassfilter geführt. dessen Einfluss wird natürlich bei der weiteren Verwendung der diskreten Spektrumsfunktion berücksichtigt.

Mit Hilfe der nach dem vorgenannten Verfahren ermittelten Spektralwerte läßt sich dann die längenabhängige Dämpfungsfunktion nach der folgen Gleichung (6) ermitteln:

$$|k_D(f,l)| = \frac{1}{\int_{min}^{f_{max}} I(f)^{\frac{\ln(10)}{10}\cdot a\cdot f^b\cdot l_0}\cdot df} \tag{6}$$

Zur Lösung des integrals in Gleichung (6):

Die Berechnung des Integrals erfolgt nach mittels bekannter numerischer Verfahren, da das Spektrum des Impulses bzw. der Impulsfolge nur diskret vorliegt.

Für jeden Wert r*(t) lässt sich nun ein Wert der Korrekturfunktion I(f, I) angeben.
Durch Multiplikation der Werte des Reflektionsfaktors r*(t) mit den entsprechenden Werten der Korrekturfunktion k(f, I) erhält man nun einen dämpfungskorrigierten Wert r(t) des Reflektionsfaktors.

## Patentansprüche

1. Verfahren zur Korrektur der frequenzabhängigen Leitungsdämpfung bei TDR-Messungen an Hochfrequenzkabeln und -leitungen, wobei die Messungen mittels Impulsen bzw. Impulsfolgen erfolgt, die auf die zu messenden Hochfrequenzkabel und -leitungen gespeist werden, **gekennzeichnet durch** folgende Schritte:

   Ermitteln des längenabhängigen Dämpfungsverlaufs ($a_{Rn}$) des zu messenden Kabels über den gesamten zu messenden Frequenzbereich;
   Ermitteln des Spektrums des genannten Impulses bzw. der Impulsfolge; Ermitteln einer Korrekturfunktion ($k_p(f,l)$) zur Korrektur des ermittelten Dämpfungsverlaufs ($a_{Rn}$) unter Verwendung des vorgenannten Spektrums;
   Korrektur der transformierten Werte r*(t) mit Hilfe der Korrekturfunktion $k_D(f,l)$ zu korrigierten Messwerten r(t).

2. Verfahren nach Anspruch 1, **dadurch gekennzeichnet, dass** der Dämpfungsverlauf ($a_{Rn}$) des Kabels anhand kabelspezifischer Parameter a,b durch Messung an einem Kabel einer bestimmten Länge ermittelt wird.

3. Verfahren nach Anspruch 1 oder 2, **dadurch gekennzeichnet, dass** die für beliebige Kabellängen gültige Korrekturfunktion aus den kabelspezifischen Parametern a,b ermittelt wird.

4. Verfahren nach einem der Ansprüche 1 - 3, **dadurch gekennzeichnet, dass** der Impuls bzw. die Impulsfolge unter Zwischenschaltung eines Hochpassfilters angeschlossen wird.

5. Verfahren nach einem der Ansprüche 1 - 4, **dadurch gekennzeichnet, dass** das Spektrum des Impulses bzw. der Impulsfolge unter Verwendung einer Kalibriermessung mit einem spezifischen Abschluss als Messobjekt durchgeführt wird und die so ermittelten Messdaten gespeichert werden.

6. Verfahren nach einem der Ansprüche 1 - 5, **dadurch gekennzeichnet, dass** die Messdaten als Amplitudenwerte über der Zeit diskret als Datensatz aufgenommen werden.

7. Verfahren nach Anspruch 6, **dadurch gekennzeichnet, dass** der Datensatz mittels Diskreter Fouriertransformation (DFT) in den Frequenzbereich transformiert wird.

8. Verfahren nach einem der Ansprüche 1 bis 7, **dadurch gekennzeichnet, dass** eine längen- und frequenzabhängige Korrekturfunktion $k_D(f,l)$ für jeden Zeit- oder Längenpunkt ermittelt wird.

9. Verfahren nach einem der Ansprüche 1 bis 8, **dadurch gekennzeichnet, dass** jeder Längenpunkt der TDR-Messung mit der Korrekturfunktion $k_D(f,l)$ multipliziert wird und **dadurch** die korrigierte Impulsantwort ergibt.

10. Verfahren nach einem der Ansprüche 1 - 9, **dadurch gekennzeichnet, daß** die korrigierte Impulsantwort abgespeichert und/oder numerisch oder graphisch dargestellt werden.

## Revendications

1. Procédé pour corriger l'affaiblissement de ligne dépendant de la fréquence lors des mesures par réflectométrie temporelle sur des câbles et des lignes haute fréquence, les mesures ayant lieu à l'aide d'impulsions ou de suites d'impulsions qui sont transmises aux câbles et lignes haute fréquence à mesurer, **caractérisé par** les étapes suivantes :

   - recherche de la courbe d'affaiblissement en fonction de la longueur ($a_{Rn}$) du câble à mesurer, sur toute la plage de fréquence à mesurer ;
- recherche du spectre de l'impulsion ou de la suite d'impulsions ;
- recherche d'une fonction de correction ($k_D(f,1)$) pour la correction de la courbe d'affaiblissement ($a_{Rn}$) déterminée, à l'aide du spectre mentionné ;
- correction des valeurs transformées r*(t) à l'aide de la fonction de correction $k_D(f,l)$ pour des valeurs de mesure corrigées r(t).

2. Procédé selon la revendication 1, **caractérisé en ce que** la courbe d'affaiblissement ($a_{Rn}$) du câble est recherchée à l'aide de paramètres a, b propres au câble, grâce à une mesure sur un câble d'une longueur définie.

3. Procédé selon la revendication 1 ou 2, **caractérisé en ce que** la fonction de correction valable pour n'importe quelles longueurs de câble est recherchée à partir des paramètres a, b propres aux câbles.

4. Procédé selon l'une des revendications 1 à 3, **caractérisé en ce que** l'impulsion ou la suite d'impulsions sont connectées à l'aide d'un filtre passe-haut intercalé.

5. Procédé selon l'une des revendications 1 à 4, **caractérisé en ce que** le spectre de l'impulsion ou de la suite d'impulsions est réalisé à l'aide d'une mesure d'étalonnage avec une terminaison spécifique comme objet de mesure, et les données de mesure ainsi déterminées sont mises en mémoire.

6. Procédé selon l'une des revendications 1 à 5, **caractérisé en ce que** les données de mesure sont enregistrées discrètement comme valeurs d'amplitude sur le temps, sous la forme d'un enregistrement logique.

7. Procédé selon la revendication 6, **caractérisé en ce que** l'enregistrement logique est transformé à l'aide d'une transformée de Fourier discrète (DFT) dans la plage de fréquence.

8. Procédé selon l'une des revendications 1 à 7, **caractérisé en ce qu'**une fonction de correction en fonction de la longueur et de la fréquence $k_D(f,l)$ est recherchée pour chaque point dé temps ou de longueur.

9. Procédé selon l'une des revendications 1 à 8, **caractérisé en ce que** chaque point de longueur de la mesure par réflectométrie temporelle est multiplié par la fonction de correction $k_D(f,l)$ et donne ainsi la réponse d'impulsion corrigée.

10. Procédé selon l'une des revendications 1 à 9, **caractérisé en ce que** la réponse d'impulsion corrigée est mise en mémoire et/ou présentée de manière numérique ou graphique.

**Claims**

1. Method for correcting the frequency-dependent line loss in TDR measurements on high-frequency cables and lines, wherein the measurements are done by means of pulses or pulse trains which are fed on to the high-frequency cables and lines to be measured, **characterised by** the following steps:

    determining the length-dependent loss progress ($a_{Rn}$) of the cable to be measured over the entire frequency range to be measured;
    determining the spectrum of said pulse or the pulse train;
    determining a correction function ($k_D(f,l)$) for correcting the loss progress ($a_{Rn}$) determined using said spectrum;
    correcting the transformed values r*(t) with the aid of the correction function $k_D(f,l)$ into corrected measured values r(t).

2. Method according to claim 1, **characterised in that** the loss progress ($a_{Rn}$) of the cable is determined using cable-specific parameters a, b by measuring on a cable of a particular length.

3. Method according to claim 1 or 2, **characterised in that** the correction function valid for any cable lengths is determined from the cable-specific parameters a, b.

4. Method according to one of claims 1 to 3, **characterised in that** the pulse or the pulse train is connected with intermediate switching of a high-pass filter.

5. Method according to one of claims 1 to 4, **characterised in that** the spectrum of the pulse or the pulse train is carried out using a calibration measurement with a specific termination as measuring object and the thus determined measured data are stored.

6. Method according to one of claims 1 to 5, **characterised in that** the measured data are recorded discretely as a data set as amplitude values over the time.

7. Method according to claim 6, **characterised in that** the data set is transformed into the frequency range by means of discrete Fourier transformation (DFT).

8. Method according to one of claims 1 to 7, **characterised in that** a length- and frequency-dependent correction function $k_D(f,l)$ is determined for each time or length point.

9. Method according to one of claims 1 to 8, **characterised in that** each length point of the TDR measurement is multiplied by the correction function $k_D(f,l)$ and thereby produces the corrected impulse response.

10. Method according to one of claims 1 to 9, **characterised in that** the corrected impulse response is stored and/or represented numerically or graphically.

FIG. 1

EP 1 156 341 B1